# EUROPÄISCHE PATENTANMELDUNG

(11) **EP 3 035 370 A1**
(43) Veröffentlichungstag der Anmeldung: **22.06.2016**
(21) Anmeldenummer: 16153590.1
(22) Anmeldetag: 24.07.2012
(51) Int. Cl.: H01L 21/18, H01L 21/20, H01L 21/67, H01J 37/32, B32B 37/00, B32B 38/10

(54) **VORRICHTUNG ZUM PERMANENTEN BONDEN VON WAFERN**

(62) Teilanmeldung aus: 12742856.3
(71) Anmelder: EV Group E. Thallner GmbH, 4782 St. Florian am Inn (AT)
(72) Erfinder: Plach, Thomas, 4651 Stadl -Paura (AT); Hingerl, Kurt, 4493 Wolfern (AT); Wimplinger, Markus, 4910 Ried im Innkreis (AT); Flötgen, Christoph, 4782 Pramerdorf (AT)
(74) Vertreter: Schweiger, Johannes

(57) **Zusammenfassung**

Die vorliegende Erfindung betrifft eine Vorrichtung zum Bonden einer ersten Kontaktfläche (3) eines ersten Substrats (1) mit einer zweiten Kontaktfläche (4) eines zweiten Substrats (2), wobei das zweite Substrat (2) zumindest eine Reaktionsschicht (7) aufweist, mit folgenden Merkmalen.
- eine Bondkammer (20, 20', 27),
- eine erste Elektrode (21) und eine gegenüberliegend angeordnete zweite Elektrode (22),
- Aufnahmemittel zur Aufnahme der Substrate (2, 3) zwischen die erste Elektrode (21) und die zweite Elektrode (22),
- Reservoirbildungsmittel zur Ausbildung eines Reservoirs (5) in einer Reservoirbildungsschicht (6) an der ersten Kontaktfläche (3) durch Beaufschlagung der ersten Kontaktfläche (3) mit einem mittels kapazitiver Kopplung der Elektroden (21, 22) erzeugten Plasma, wobei an der ersten Elektrode (21) während der Plasmaerzeugung eine von einer zweiten Frequenz (f₂₂) der zweiten Elektrode (22) unterschiedliche erste Frequenz (f₂₁) anlegbar ist,
- Mittel zum Kontaktieren der ersten Kontaktfläche (3) mit der zweiten Kontaktfläche (4) zur Ausbildung einer Pre-Bond-Verbindung,
wobei die Vorrichtung eine Kammer zur Ausbildung des Reservoirs und eine separat dazu vorgesehene Kammer zur Füllung des Reservoirs und einer, insbesondere separat vorgesehenen Kammer zur Ausbildung der Pre-Bond-Verbindung aufweist, die direkt über ein Vakuumsystem miteinander verbunden sind.

## Beschreibung

Die vorliegende Erfindung betrifft eine Vorrichtung zum Bonden einer ersten Kontaktfläche eines ersten Substrats mit einer zweiten Kontaktfläche eines zweiten Substrats gemäß den Patentansprüchen 1, 3 und 5.

Ziel beim permanenten oder irreversiblen Bonden von Substraten ist es, zwischen den beiden Kontaktflächen der Substrate eine möglichst starke und insbesondere unwiderrufliche Verbindung, also eine hohe Bondkraft, zu erzeugen. Hierfür existieren im Stand der Technik verschiedene Ansätze und Herstellungsverfahren.

Die bekannten Herstellungsverfahren und bisher verfolgten Ansätze führen häufig zu nicht oder schlecht reproduzierbaren und insbesondere kaum auf veränderte Bedingungen übertragbaren Ergebnissen. Insbesondere benutzen derzeit eingesetzte Herstellungsverfahren häufig hohe Temperaturen, insbesondere >400°C, um wiederholbare Ergebnisse zu gewährleisten.

Technische Probleme wie hoher Energieverbrauch und eine mögliche Zerstörung von auf den Substraten vorhandenen Strukturen resultieren aus den bisher für eine hohe Bondkraft erforderlichen hohen Temperaturen von teilweise weit über 300° C.

Weitere Anforderungen bestehen in:
- der Front-end-of-line-Kompatibilität.
   Darunter versteht man die Kompatibilität des Prozesses während der Herstellung der elektrisch aktiven Bauteile. Der Bondingprozess muss also so ausgelegt werden, dass aktive Bauelemente wie Transistoren, die bereits auf den Strukturwafern vorhanden sind, während der Prozessierung weder beeinträchtigt noch geschädigt werden. Zu den Kompatibilitätskriterien zählen vor allem die Reinheit an gewissen chemischen Elementen (vor allem bei CMOS Strukturen), mechanische Belastbarkeit, vor allem durch Thermospannungen.
- niedrige Kontamination.
- keine Krafteinbringung.
- möglichst niedrige Temperatur, insbesondere bei Materialien mit unterschiedlichen thermischen Ausdehnungskoeffizienten.

Die Reduktion der Bondkraft führt zu einer schonenderen Behandlung der Strukturwafer, und damit zu einer Reduktion der Ausfallswahrscheinlichkeit durch direkte mechanische Belastung.

Die EP0584778A2 offenbart ein Bond-Verfahren, bei dem eine Bindungsförderungsschicht in die Oberfläche einer Isolierungsschicht implantiert wird. Die US5,427,638 betrifft ein Bond-Verfahren, bei dem polierte und gereinigte Oberflächen mit Ionen beaufschlagt werden. Die JP5166690A offenbart ein Laminierverfahren.

Aufgabe der vorliegenden Erfindung ist es daher, eine Vorrichtung zur schonenden Herstellung eines permanenten Bonds mit einer möglichst hohen Bondkraft bei gleichzeitig möglichst niedriger Temperatur anzugeben.

Diese Aufgabe wird mit den Merkmalen der Patentansprüche 1, 3 und 5 gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen. Bei angegebenen Wertebereichen sollen auch innerhalb der genannten Grenzen liegende Werte als Grenzwerte offenbart gelten und in beliebiger Kombination beanspruchbar sein.

Die Grundidee der vorliegenden Erfindung ist es, mit Hilfe eines kapazitiv gekoppelten Plasmas oder eines induktiv gekoppelten Plasmas oder einem Plasma aus einer Remoteplasmaanlage ein Plasma zu erzeugen, mit dessen Hilfe ein Reservoir zur Aufnahme eines ersten Edukts in einem Substrat geschaffen wird, das nach der Kontaktierung beziehungsweise Herstellung eines vorläufigen Bonds zwischen den Substraten mit einem zweiten Edukt, das in dem anderen Substrat vorliegt, reagiert und dadurch einen irreversiblen beziehungsweise permanenten Bond zwischen den Substraten ausbildet. Vor oder nach der Ausbildung des Reservoirs in einer Reservoirbildungsschicht an der ersten Kontaktfläche findet meist eine Reinigung des oder der Substrate, insbesondere durch einen Spülschritt, statt. Diese Reinigung soll zumeist sicherstellen, dass sich keine Partikel auf den Oberflächen befinden, die ungebondete Stellen zur Folge haben würden. Durch das Reservoir und das im Reservoir enthaltene Edukt wird eine technische Möglichkeit geschaffen, unmittelbar an den Kontaktflächen nach der Herstellung des vorläufigen beziehungsweise reversiblen Bonds gezielt eine den permanenten Bond verstärkende und die Bondgeschwindigkeit erhöhende Reaktion (erstes Edukt oder erste Gruppe mit dem zweiten Edukt oder der zweiten Gruppe) zu induzieren, insbesondere durch Verformung mindestens einer der Kontaktflächen durch die Reaktion, vorzugsweise der dem Reservoir gegenüberliegenden Kontaktfläche. An der gegenüberliegenden zweiten Kontaktfläche ist erfindungsgemäß eine Aufwuchsschicht vorgesehen, in der die erfindungsgemäße Verformung stattfindet beziehungsweise das erste Edukt (oder die erste Gruppe) mit dem in der Reaktionsschicht des zweiten Substrats vorliegenden zweiten Edukt (oder der zweiten Gruppe) reagiert. Zur Beschleunigung der Reaktion zwischen dem ersten Edukt (oder der ersten Gruppe) und dem zweiten Edukt (oder der zweiten Gruppe) ist erfindungsgemäß in einer vorteilhaften Ausführungsform vorgesehen, die zwischen der Reaktionsschicht des zweiten Substrats und dem Reservoir liegende Aufwuchsschicht vor Kontaktierung der Substrate zu dünnen, da hierdurch der Abstand zwischen den Reaktionspartnern einstellbar verringert wird und gleichzeitig die erfindungsgemäße Verformung/Ausbildung der Aufwuchsschicht begünstigt wird. Die Aufwuchsschicht wird durch das Dünnen zumindest teilweise, insbesondere überwiegend, vorzugsweise vollständig, entfernt. Die Aufwuchsschicht wächst bei der Reaktion des ersten Edukts mit dem zweiten Edukt wieder an, auch wenn diese vollständig entfernt wurde. Das Dünnen dieser Aufwuchsschicht könnte erfindungsgemäß insbesondere mittels Ätzen, insbesondere Trockenätzen, Polieren, Sputtern oder Reduktion von Oxiden erfolgen. Mit Vorzug ist auch eine Kombination dieser Verfahren, insbesonderer Sputtern und Oxidreduktion, denkbar,

Erfindungsgemäß können Mittel zur Hemmung des Anwachsens der Aufwuchsschicht vor dem Kontaktieren der Kontaktflächen vorgesehen sein, insbesondere durch Passivierung der Reaktionsschicht des zweiten Substrats, vorzugsweise durch Beaufschlagung mit N₂, Formiergas oder einer inerten Atmosphäre oder unter Vakuum oder durch Amorphisieren. Als besonders geeignet hat sich in diesem Zusammenhang eine Behandlung mit Plasma, welches Formiergas enthält, insbesondere überwiegend aus Formiergas besteht, erwiesen. Als Formiergas sind hier Gase zu verstehen, die mindestens 2%, besser 4%, idealerweise 10% oder 15% Wasserstoff enthalten. Der restliche Anteil der Mischung besteht aus einem inerten Gas wie beispielsweise Stickstoff oder Argon.

Bei der Verwendung von Formiergas ist es insbesondere möglich, die Oxidschicht durch einen Prozess, der auf Sputtern und Oxidreduktion beruht, zu dünnen.

Alternativ oder zusätzlich zu dieser Maßnahme ist es erfindungsgemäß von Vorteil, die Zeit zwischen dem Dünnen und der Kontaktierung zu minimieren, insbesondere <2 Stunden, vorzugsweise <30 Minuten, noch bevorzugter <15 Minuten, idealerweise <5 Minuten. Damit lässt sich das Oxidwachstum, welches nach dem Dünnen erfolgt, minimieren.

Durch die gedünnte und dadurch zumindest beim Beginn der Ausbildung des permanenten Bonds beziehungsweise beim Beginn der Reaktion sehr dünne Aufwuchsschicht wird die Diffusionsrate der Edukte durch die Aufwuchsschicht hindurch erhöht. Dies führt zu einer geringeren Transportzeit der Edukte bei gleicher Temperatur.

Für den Pre-Bonding-Schritt zur Erzeugung eines vorläufigen oder reversiblen Bonds zwischen den Substraten sind verschiedene Möglichkeiten vorgesehen mit dem Ziel, eine schwache Interaktion zwischen den Kontaktflächen der Substrate zu erzeugen. Die Prebondstärken liegen dabei unter den Permanentbondstärken, zumindest um den Faktor 2 bis 3, insbesondere um den Faktor 5, vorzugsweise um den Faktor 15, noch bevorzugter um den Faktor 25.Als Richtgrößen werden die Pre-Bondstärken von reinem, nicht aktiviertem, hydrophilisierten Silizium mit ca. 100mJ/m² und von reinem, plasmaaktivierten hydrophiliserten Silizium mit ca. 200-300mJ/m² erwähnt. Die Prebonds zwischen den mit Molekülen benetzten Substraten kommen hauptsächlich durch die van-der-Waals Wechselwirkungen zwischen den Molekülen der unterschiedlichen Waferseiten zustande. Dementsprechend sind vor allem Moleküle mit permanenten Dipolmomenten dafür geeignet, Prebonds zwischen Wafern zu ermöglichen. Als Verbindungsmittel werden folgende chemische Verbindungen beispielhaft, aber nicht einschränkend, genannt
- Wasser,
- Tiole,
- AP3000,
- Silane und/oder
- Silanole

Als erfindungsgemäße Substrate sind solche Substrate geeignet, deren Material in der Lage ist, als Edukt mit einem weiteren zugeführten Edukt zu einem Produkt mit einem höheren molaren Volumen zu reagieren, wodurch die Bildung einer Aufwuchsschicht auf dem Substrat bewirkt wird. Besonders vorteilhaft sind die nachfolgenden Kombinationen, wobei jeweils links vom Pfeil das Edukt und rechts vom Pfeil das Produkt / die Produkte genannt ist, ohne das mit dem Edukt reagierende zugeführte Edukt oder Nebenprodukte im Einzelnen zu benennen:
- Si→SiO₂, Si₃N₄, SiNₓO_{y}
- Ge→ GeO₂, Ge₃N₄
- α-Sn→ SnO₂
- B→ B₂O₃, BN
- Se→ SeO₂
- Te→ TeO₂, TeO₃
- Mg→ MgO, Mg₃N₂
- Al→ Al₂O₃, AlN
- Ti→ TiO₂, TiN
- V→ V₂O₅
- Mn→ MnO, MnO₂, Mn₂O₃, Mn₂O₇, Mn₃O₄
- Fe → FeO, Fe₂O₃, Fe₃O₄
- Co→ CoO, Co₃O₄,
- Ni→ NiO, Ni₂O₃
- Cu→ CuO Cu₂O, Cu₃N
- Zn→ ZnO
- Cr→ CrN, Cr₂₃C₆, Cr₃C, Cr₇C₃, Cr₃C₂
- Mo→ Mo₃C₂
- Ti→ TiC
- Nb→ Nb₄C₃
- Ta→ Ta₄C₃
- Zr→ ZrC
- Hf→ HfC
- V→ V₄C₃, VC
- W→ W₂C, WC
- Fe→ Fe₃C, Fe₇C₃, Fe₂C.

Als Substrate sind außerdem folgende Mischformen von Halbleitern denkbar:
- III-V: GaP, GaAs, InP, InSb, InAs, GaSb, GaN, AlN, InN, AlₓGa₁₋ₓAs, InₓGa₁₋ₓN
- IV-IV: SiC, SiGe,
- III-VI: InAlP.
- nichtlineare Optik: LiNbO₃, LiTaO₃, KDP (KH₂PO₄)
- Solarzellen: CdS, CdSe, CdTe, CulnSe₂, CuInGaSe₂, CuInS₂, CuInGaS₂
- Leitende Oxide: In₂₋ₓSnxO_{3-y}

Erfindungsgemäß wird das Reservoir (oder die Reservoirs) an mindestens einem der Wafer, und zwar unmittelbar an der jeweiligen Kontaktfläche, vorgesehen, in welchem eine gewisse Menge mindestens eines der zugeführten Edukte für die Volumenexpansionsreaktion speicherbar ist. Edukte können also beispielsweise O₂, O₃, H₂O, N2, NH3, H₂O₂ etc. sein. Durch die Expansion, insbesondere bedingt durch Oxidwachstum, werden auf Grund der Bestrebung der Reaktionspartner, die Systemenergie abzusenken, etwaige Lücken, Poren, Hohlräume zwischen den Kontaktflächen minimiert und die Bondkraft entsprechend durch Annäherung der Abstände zwischen den Substraten in diesen Bereichen erhöht. Im bestmöglichen Fall werden die vorhandenen Lücken, Poren und Hohlräume komplett geschlossen, sodass die gesamte Bondingfläche zunimmt und damit die Bondkraft erfindungsgemäß entsprechend steigt.

Die Kontaktflächen zeigen üblicherweise eine Rauhigkeit mit einer quadratischen Rauheit (Rq) von 0,2 nm auf. Dies entspricht Scheitel-ScheitelWerten der Oberflächen im Bereich von 1 nm. Diese empirischen Werte wurden mit der Atomic Force Microscopy (AFM) ermittelt.

Die erfindungsgemäße Reaktion ist geeignet, bei einer üblichen Waferfläche eines kreisförmigen Wafers mit einem Durchmesser von 200 bis 300 mm mit 1 Monolage (ML) Wasser die Aufwuchsschicht um 0,1 bis 0,3 nm wachsen zu lassen.

Erfindungsgemäß ist daher insbesondere vorgesehen, mindestens 2 ML, vorzugsweise mindestens 5 ML, noch bevorzugter mindestens 10 ML Fluid, insbesondere Wasser, im Reservoir zu speichern.

Besonders bevorzugt ist die Ausbildung des Reservoirs durch Plasmabeaufschlagung, da durch die Plasmabeaufschlagung außerdem eine Glättung der Kontaktfläche sowie eine Hydrophilisierung als Synergieeffekte bewirkt werden. Die Glättung der Oberfläche durch Plasmaaktivierung erfolgt vorwiegend durch einen viskosen Fluss des Materials der Reservoirbildungsschicht und gegebenenfalls der Reaktionsschicht. Die Erhöhung der Hydrophilizität erfolgt insbesondere durch die Vermehrung der Siliziumhydroxyl Verbindungen, vorzugsweise durch Cracken von an der Oberfläche vorhandenen Si-O Verbindungen wie Si-O-Si, insbesondere gemäß nachfolgender Reaktion:

Si-O-Si + H₂O ←→ 2SiOH

Ein weiterer Nebeneffekt, insbesondere als Folge der vorgenannten Effekte, besteht darin, dass die Pre-Bond-Stärke, insbesondere um einen Faktor 2 bis 3, verbessert wird.

Die Ausbildung des Reservoirs in der Reservoirbildungsschicht an der ersten Kontaktfläche des ersten Substrats (und gegebenenfalls einer Reservoirbildungsschicht an der zweiten Kontaktfläche des zweiten Substrats) erfolgt beispielsweise durch Plasmaaktivierung des mit einem thermischen Oxid beschichteten ersten Substrats. Die Plasmaaktivierung wird in einer Vakuumkammer durchgeführt, um die für das Plasma erforderlichen Bedingungen einstellen zu können. Erfindungsgemäß wird für die Plasmaentladung N₂-Gas, O₂-Gas oder Argongas mit Ionenenergien im Bereich von 0 bis 2000 eV (Amplitude) verwendet, wodurch ein Reservoir mit einer Tiefe von bis zu 20 nm, vorzugsweise bis zu 15 nm, mit größerem Vorzug bis zu 10nm, mit größtem Vorzug bis zu 5nm, der behandelten Oberfläche, in diesem Fall der ersten Kontaktfläche, hergestellt wird.

Durch Einstellung eines bestimmten Drucks in der Vakuumkammer ist eine Einflussnahme beziehungsweise Einstellung der mittleren freien Weglänge für die Plasmaionen erfindungsgemäß denkbar.

Durch die erfindungsgemäße Verwendung zweier unterschiedlicher Frequenzen an den gegenüberliegenden Elektroden zur Erzeugung des Plasmas, die insbesondere unter Anlegen eines Wechselstroms beziehungsweise einer Wechselspannung die Plasmaionen beschleunigen, und/oder einer induktiv gekoppelten Plasmaquelle und/oder einem Remoteplasma sind reproduzierbare Ergebnisse bei der Erzeugung des Reservoirs an der/den Kontaktflächen möglich.

Im Falle der kapazitiven Kopplung ist es vorteilhaft, wenn die Elektroden innerhalb der Plasmakammer angeordnet sind.

Dabei wird durch Einstellung der Parameter (unterschiedliche) Frequenzen der Elektroden, Amplituden, einer, insbesondere, vorzugsweise ausschließlich, an der zweiten Elektrode angelegten Biasspannung und Kammerdruck eine optimale Beaufschlagung der Kontaktflächen und somit Erzeugung eines exakt, insbesondere volumenmäßig und/oder tiefenmäßig definierten Reservoirs ermöglicht.

Die Ausführung der Plasmaaktivierungsanlage als kapazitiv gekoppelte Doppelfrequenz-Plasmaanlage ermöglicht mit Vorteil ein getrenntes Einstellen der Ionendichte und der Beschleunigung der Ionen auf die Waferoberfläche. Somit lassen sich erzielbare Prozessergebnisse in einem breiten Fenster einstellen und optimal an die Erfordernisse der Anwendung anpassen.

Die Biasspannung dient, insbesondere in Form einer Grundspannung der zweiten, insbesondere unteren, Elektrode dazu, das Auftreffen (Geschwindigkeit) der Elektroden auf die Kontaktfläche des auf der zweiten Elektrode aufgenommenen Substrats zu beeinflussen, insbesondere zu dämpfen oder zu beschleunigen.

Durch die vorgenannten Parameter wird insbesondere die Porendichteverteilung im Reservoir einstellbar, wobei nachfolgend besonders vorteilhafte Ausführungsformen beschrieben werden.

Bei einer induktiv gekoppelten Plasmaquelle können entsprechende Analogieüberlegungen über die Wechselspannung der kapazitiven Kopplung auf Wechselströme, die zur Erzeugung eines magnetischen Feldes genutzt werden, übernommen werden. Erfindungsgemäß ist es denkbar, das Plasma der induktiv gekoppelten Plasmaquelle durch einen Wechselstrom bzw. magnetisches Wechselfeld unterschiedlicher Stärke und/oder Frequenz so zu manipulieren, dass das Plasma entsprechende erfindungsgemäße Eigenschaften aufweist.

Bei einem Remoteplasma, wird das eigentlich zu verwendende Plasma in einer externen Quelle erzeugt, und in den Probenraum eingeführt. Insbesondere werden Bestandteile dieses Plasmas, insbesondere Ionen, in den Probenraum transportiert. Der Übergang des Plasmas vom Quellen- in den Substratraum kann durch unterschiedliche Elemente wie Schleusen, Beschleuniger, magnetische und/oder elektrische Linsen, Blenden etc. gewährleistet werden. Alle für das kapazitiv und/oder induktiv gekoppelte Plasma geltenden Überlegungen bezüglich Frequenzen und/oder Stärken der elektrischen und/oder magnetischen Felder soll für sämtliche Elemente, welche die Erzeugung und/oder den Übergang des Plasmas vom Quellen- in den Substratraum gewährleisten gelten. Denkbar wäre beispielsweise, dass ein Plasma durch kapazitive oder induktive Kopplung durch die erfindungsgemäßen Parameter im Quellenraum erzeugt wird und danach über die oben offenbarten Elemente in den Substratraum eindringt.

Erfindungsgemäß können jede Partikelart, Atome und/oder Moleküle, verwendet werden, die geeignet sind, das Reservoir zu erzeugen. Mit Vorzug werden jene Atome und/oder Moleküle verwendet, welche das Reservoir mit den benötigten Eigenschaften erzeugt. Die relevanten Eigenschaften sind vor allem die Porengröße, Porenverteilung und Porendichte. Alternativ können erfindungsgemäß Gasmischungen, wie beispielsweise Luft oder Formiergas bestehend aus 95% Ar und 5% H₂ verwendet werden. Abhängig von dem verwendeten Gas sind in dem Reservoir während der Plasmabehandlung unter anderem folgende Ionen anwesend: N+, N₂+, O+, O₂+, Ar+. Im nicht belegten Freiraum des/der Reservoirs ist das erste Edukt aufnehmbar. Die Reservoirbildungsschicht und entsprechend das Reservoir kann sich bis in die Reaktionsschicht hinein erstrecken.

Mit Vorteil handelt es sich dabei um unterschiedliche Arten von Plasmaspezies, die mit der Reaktionsschicht reagieren können und zumindest teilweise, vorzugsweise überwiegend aus dem ersten Edukt bestehen. Soweit das zweite Edukt Si/Si ist, wäre eine Ox-Plasmaspezies vorteilhaft.

Die Ausbildung des/der Reservoirs erfolgt auf Grund folgender Überlegungen:
Die Porengröße ist kleiner als 10nm, mit Vorzug kleiner als 5nm, mit größerem Vorzug kleiner als 1nm, mit noch größerem Vorzug kleiner als 0.5nm, mit größtem Vorzug kleiner als 0.2nm.

Die Porendichte ist mit Vorzug direkt proportional zur Dichte der Partikel, welche die Poren durch Einschlagwirkung erzeugen, mit größtem Vorzug sogar durch den Partialdruck der Einschlagspezies variierbar, sowie abhängig von der Behandlungszeit und den Parametern, insbesondere des verwendeten Plasmasystems.

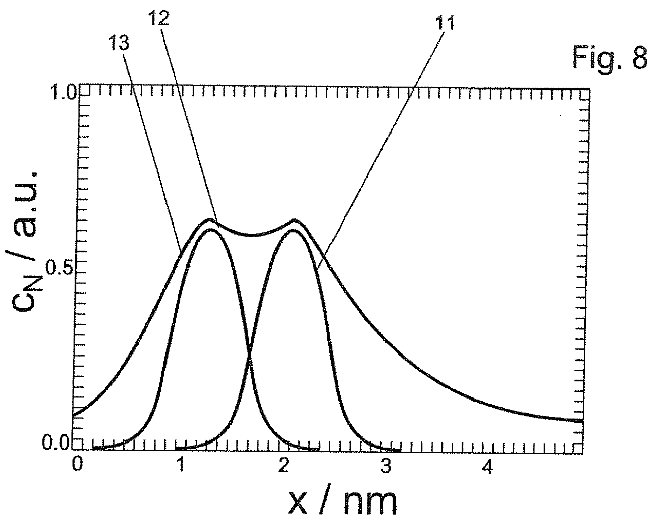

Die Porenverteilung besitzt mit Vorzug mindestens einen Bereich größter Porenkonzentration unter der Oberfläche, durch Variation der Parameter mehrerer solcher Bereiche, welche sich zu einem, vorzugsweise plateauförmigen Bereich, überlagern (siehe Fig. 8). Die Porenverteilung nimmt mit zunehmender Dicke gegen null ab. Der oberflächennahe Bereich besitzt während des Beschusses eine Porendichte, welche mit der Porendichte nahe der Oberfläche beinahe ident ist. Nach dem Ende der Plasmabehandlung kann die Porendichte an der Oberfläche auf Grund von Spannungsrelaxationsmechanismen verringert werden. Die Porenverteilung in Dickenrichtung besitzt bezüglich der Oberfläche eine steile Flanke und bezüglich des Bulks eine eher flachere, aber stetig abnehmende Flanke (siehe Fig. 8).

Für die Porengröße, die Porenverteilung und Porendichte gelten für alle nicht mit Plasma hergestellten Verfahren ähnliche Überlegungen.

Das Reservoir kann durch gezielte Verwendung und Kombination von Prozessparametern designed werden. Fig. 8 zeigt eine Darstellung der Konzentration eingeschossener Stickstoffatome durch Plasma als Funktion der Eindringtiefe in eine Siliziumoxidschicht. Durch Variation der physikalischen Parameter konnten zwei Profile erzeugt werden. Das erste Profil 11 wurde durch stärker beschleunigte Atome tiefer im Siliziumoxid erzeugt, wohingegen das Profil 12, nach Abänderung der Prozessparameter in einer geringeren Dichte erzeugt wurde. Die Überlagerung beider Profile ergibt eine Summenkurve 13, welche charakteristisch für das Reservoir steht. Der Zusammenhang zwischen der Konzentration der eingeschossenen Atom und/oder Molekülspezies ist evident. Höhere Konzentrationen bezeichnen Gebiete mit höherer Defektstruktur, also mehr Raum um das anschließende Edukt aufzunehmen. Eine kontinuierliche, insbesondere gezielt gesteuerte kontinuierliche Änderung der Prozessparameter während der Plasmaaktivierung ermöglicht es, ein Reservoir mit einer möglichst gleichmäßigen Verteilung der eingebrachten Ionen über die Tiefe zu erreichen.

Als Reservoir ist alternativ zu einem durch Plasma erzeugten Reservoir die Verwendung einer TEOS (Tetraethylorthosilikat)-Oxidschicht auf mindestens einem der Substrate, zumindest dem ersten Substrat, denkbar. Dieses Oxid ist im allgemeinen weniger dicht als thermisches Oxid, weshalb erfindungsgemäß eine Verdichtung vorteilhaft ist. Die Verdichtung erfolgt durch Wärmebehandlung mit dem Ziel einer Einstellung einer definierten Porosität des Reservoirs.

Besonders vorteilhaft kann gemäß einer Ausführungsform der Erfindung die Auffüllung des Reservoirs gleichzeitig mit der Ausbildung des Reservoirs erfolgen, indem das Reservoir als Beschichtung auf dem ersten Substrat aufgebracht wird, wobei die Beschichtung das erste Edukt bereits umfasst.

Das Reservoir ist als poröse Schicht mit einer Porosität im Nanometerbereich oder als Kanäle aufweisende Schicht mit einer Kanaldicke kleiner 10nm, mit größerem Vorzug kleiner als 5 nm, mit noch größerem Vorzug kleiner als 2nm, mit größtem Vorzug kleiner als 1nm, mit allergrößtem Vorzug kleiner als 0.5nm denkbar.

Für den Schritt des Auffüllens des Reservoirs mit dem ersten Edukt oder einer ersten Gruppe von Edukten sind erfindungsgemäß folgende Ausführungsformen, auch in Kombination, denkbar:
- Aussetzen des Reservoirs gegenüber der Umgebungsatmosphäre,
- Spülung mit, insbesondere deionisiertem, Wasser,
- Spülen mit einem das Edukt enthaltenden oder aus diesem bestehenden Fluid, insbesondere H₂O, H₂O₂, NH4OH
- Aussetzen des Reservoirs gegenüber einer beliebigen Gasatmosphäre, insbesondere atomares Gas, molekulares Gas, Gasmischungen,
- Aussetzen des Reservoirs gegenüber einer Wasserdampf oder Wasserstoffperoxiddampf enthaltenden Atmosphäre und
- Ablagerung eines bereits mit dem Edukt befüllten Reservoirs als Reservoirbildungsschicht auf dem ersten Substrat.

Als Edukte kommen die folgenden Verbindungen in Frage: Ox⁺, O₂, O₃, N₂, NH₃, H₂O, H₂O₂ und/oder NH₄OH.

Die Verwendung des oben angeführten Wasserstoffperoxiddampfes wird neben der Verwendung von Wasser als bevorzugte Variante angesehen. Wassertstoffperoxid hat des Weiteren den Vorteil, ein größeres Sauerstoffzu Wasserstoffverhältnis zu besitzen. Des Weiteren dissoziiert Wasserstoffperoxid über bestimmten Temperaturen und/oder der Verwendung von Hochfrequenzfeldern im MHz Bereich zu Wasserstoff und Sauerstoff.

Andererseits bietet H₂O den Vorteil, eine kleine Molekülgröße aufzuweisen. Die Größe des H₂O-Moleküls ist sogar kleiner als jene des O₂-Moleküls, womit H₂0 den Vorteil bietet, leichter in den Poren eingelagert werden zu können, sowie leichter durch die Aufwuchsschicht hindurch diffundieren zu können.

Vor allem bei Verwendung von Materialien mit unterschiedlichen thermischen Ausdehnungskoeffizienten ist die Anwendung von Verfahren zur Dissoziierung der vorgenannten Spezies vorteilhaft, die keine nennenswerte oder allenfalls eine lokale/spezifische Temperaturerhöhung bewirken. Insbesondere ist eine Mikrowellenbestrahlung vorgesehen, welche die Dissoziierung zumindest begünstigt, vorzugsweise bewirkt.

Gemäß einer vorteilhaften Ausführungsform der Erfindung ist vorgesehen, dass die Ausbildung der Aufwuchsschicht und Verstärkung des irreversiblen Bonds durch Diffusion des ersten Edukts in die Reaktionsschicht erfolgt.

Gemäß einer weiteren, vorteilhaften Ausführungsform der Erfindung ist vorgesehen, dass die Ausbildung des irreversiblen Bonds bei einer Temperatur von typischerweise weniger als 300°C, mit Vorteil von weniger als 200°C, mit größerem Vorzug weniger als 150°C, mit noch größerem Vorzug weniger als 100°C, mit größtem Vorzug bei Raumtemperatur insbesondere während maximal 12 Tage, bevorzugter maximal 1 Tag, noch bevorzugter maximal 1 Stunde, am bevorzugtesten maximal 15 Minuten, erfolgt. Eine weitere, vorteilhafte Wärmebehandlungsmethode ist die dielektrische Erwärmung durch Mikrowellen.

Dabei ist es besonders vorteilhaft, wenn der irreversible Bond eine Bondstärke von größer 1,5 J/m², insbesondere größer 2 J/m², vorzugsweise größer 2,5 J/m² aufweist.

Die Bondstärke kann in besonders vorteilhafter Weise dadurch erhöht werden, dass bei der Reaktion erfindungsgemäß ein Produkt mit einem größeren molaren Volumen als das molare Volumen des zweiten Edukts in der Reaktionsschicht gebildet wird. Hierdurch wird ein Anwachsen am zweiten Substrat bewirkt, wodurch Lücken zwischen den Kontaktflächen durch die erfindungsgemäße chemische Reaktion geschlossen werden können. Als Folge hieraus wird der Abstand zwischen den Kontaktflächen, also der mittlere Abstand, reduziert und Toträume minimiert.

Soweit die Ausbildung des Reservoirs durch Plasmaaktivierung, insbesondere mit einer Aktivierungsfrequenz zwischen 10 kHz und 20000 kHz, mit Vorzug zwischen 10 kHz und 5000 kHz, noch bevorzugter zwischen 10 kHz und 1000 kHz, mit größtem Vorzug zwischen 10 kHz und 600 kHz und/oder einer Leistungsdichte zwischen 0,075 und 0,2 Watt/cm² und/oder unter Druckbeaufschlagung mit einem Druck zwischen 0,1 und 0,6 mbar, erfolgt, werden zusätzliche Effekte wie die Glättung der Kontaktfläche als auch eine deutlich erhöhte Hydrophilität der Kontaktfläche bewirkt.

Alternativ dazu kann die Ausbildung des Reservoirs erfindungsgemäß durch Verwendung einer, insbesondere kontrolliert auf eine bestimmte Porosität verdichteten, Tetraethoxysilan-Oxidschicht als Reservoirbildungsschicht erfolgen.

Gemäß einer weiteren vorteilhaften Ausführungsform der Erfindung ist vorgesehen, dass die Reservoirbildungsschicht überwiegend, insbesondere im wesentlichen vollständig, aus einem, insbesondere amorphen, insbesondere einem durch thermische Oxidation erzeugten Siliziumdioxid, und die Reaktionsschicht aus einem oxidierbaren Material, insbesondere überwiegend, vorzugsweise im wesentlichen vollständig, aus Si, Ge, InP, GaP oder GaN (oder einem anderen, oben alternativ erwähnten Material), bestehen. Durch Oxidation wird eine besonders stabile und die vorhandenen Lücken besonders effektiv schließende Reaktion ermöglicht.

Dabei ist es erfindungsgemäß vorgesehen, dass zwischen der zweiten Kontaktfläche und der Reaktionsschicht eine Aufwuchsschicht, insbesondere überwiegend aus nativem Siliziumdioxid (oder einem anderen, oben alternativ erwähnten Material), vorgesehen ist. Die Aufwuchsschicht unterliegt einem durch die erfindungsgemäße Reaktion bewirkten Wachstum. Das Wachstum erfolgt ausgehend vom Übergang Si-SiO2 (7) durch Neubildung von amorphem SiO2 und dadurch hervorgerufener Verformung, insbesondere Ausbeulung, der Aufwuchsschicht, insbesondere an der Grenzfläche zur Reaktionsschicht, und zwar insbesondere in Bereichen von Lücken zwischen der ersten und der zweiten Kontaktfläche. Hierdurch wird eine Reduzierung des Abstands beziehungsweise Verringerung des Totraums zwischen den beiden Kontaktflächen bewirkt, wodurch die Bondstärke zwischen den beiden Substraten erhöht wird. Besonders vorteilhaft ist dabei eine Temperatur zwischen 200 und 400°C, bevorzugt in etwa 200°C und 150° C, bevorzugterweise eine Temperatur zwischen 150°C und 100°C, am bevorzugtesten eine Temperatur zwischen 100°C und Raumtemperatur. Die Aufwuchsschicht kann dabei in mehrere Aufwuchsbereiche unterteilt sein. Die Aufwuchsschicht kann gleichzeitig eine Reservoirbildungsschicht des zweiten Substrats sein, in der ein weiteres, die Reaktion beschleunigendes Reservoir ausgebildet wird.

Hierbei ist es besonders vorteilhaft, wenn die Aufwuchsschicht vor der Ausbildung des irreversiblen Bonds eine mittlere Dicke A zwischen 0,1 nm und 5 nm aufweist. Je dünner die Aufwuchsschicht, desto schneller und einfacher erfolgt die Reaktion zwischen dem ersten und dem zweiten Edukt durch die Aufwuchsschicht hindurch, insbesondere durch Diffusion des ersten Edukts durch die Aufwuchsschicht hindurch zur Reaktionsschicht. Durch die gedünnte und dadurch zumindest beim Beginn der Ausbildung des permanenten Bonds beziehungsweise beim Beginn der Reaktion sehr dünne Aufwuchsschicht wird die Diffusionsrate der Edukte durch die Aufwuchsschicht hindurch erhöht. Dies führt zu einer geringeren Transportzeit der Edukte bei gleicher Temperatur.

Hier spielt das erfindungsgemäße Dünnen eine entscheidende Rolle, da die Reaktion hierdurch weiter beschleunigt und/oder die Temperatur weiter reduziert werden können. Das Dünnen kann insbesondere durch Ätzen, vorzugsweise in feuchter Atmosphäre, noch bevorzugter in-situ, erfolgen. Alternativ erfolgt das Dünnen insbesondere durch Trockenätzen, vorzugsweise in-situ. In-situ bedeutet hier die Durchführung in ein und derselben Kammer, in der mindestens ein vorheriger und/oder ein nachfolgender Schritt durchgeführt wird/werden. Eine weitere Anlagenanordnung, die untern den, hier verwendeten in-situ Begriff fällt ist eine Anlage, bei der der Transport der Substrate zwischen einzelnen Prozesskammern in einer kontrolliert einstellbaren Atmosphäre, beispielsweise unter Verwendung inerter Gase, insbesondere aber in Vakuum Umgebung erfolgen kann. Nassätzen findet mit Chemikalien in der Dampfphase statt, währen Trockenätzen mit Chemikalien im flüssigen Zustand stattfindet. Soweit die Aufwuchsschicht aus Siliziumdioxid besteht, kann mit Flusssäure oder verdünnter Flusssäure geätzt werden. Soweit die Aufwuchsschicht aus reinem Si besteht, kann mit KOH geätzt werden.

In vorteilhafter Weise ist gemäß einer Ausführungsform der Erfindung vorgesehen, dass die Ausbildung des Reservoirs im Vakuum durchgeführt wird. Somit können Verunreinigungen des Reservoirs mit nicht erwünschten Materialien oder Verbindungen vermieden werden.

In einer weiteren Ausführungsform der Erfindung ist mit Vorteil vorgesehen, dass das Auffüllen des Reservoirs durch einen oder mehrere der nachfolgend aufgeführten Schritte erfolgt:
- Aussetzen der ersten Kontaktfläche gegenüber der Atmosphäre, zur Auffüllung des Reservoirs mit Luftfeuchtigkeit und / oder in der Luft enthaltenem Sauerstoff.
- Beaufschlagung der ersten Kontaktfläche mit einem, insbesondere überwiegend, vorzugsweise nahezu vollständig, aus, insbesondere deionisiertem, H₂O und/oder H₂O₂ bestehenden, Fluid,
- Beaufschlagung der ersten Kontaktfläche mit N₂-Gas und/oder O₂-Gas und/oder Ar-Gas und/oder Formiergas, insbesondere bestehend aus 95% Ar und 5% H₂, insbesondere mit einer Ionenenergie im Bereich von 0 bis 2000 eV.
- Bedampfung zur Auffüllung des Reservoirs mit einem beliebigen bereits genannten Edukt.

Besonders effektiv für den Verfahrensablauf ist es, wenn das Reservoir mit Vorzug in einer Dicke R zwischen 0,1 nm und 25 nm, mit größerem Vorzug zwischen 0,1 nm und 15 nm, mit noch größerem Vorzug zwischen 0,1 nm und 10 nm, mit größtem Vorzug zwischen 0,1 nm und 5 nm ausgebildet wird. Weiterhin ist es gemäß einer Ausführungsform der Erfindung vorteilhaft, wenn der mittlere Abstand B zwischen dem Reservoir und der Reaktionsschicht unmittelbar vor der Ausbildung des irreversiblen Bonds zwischen 0,1 nm und 15 nm, insbesondere zwischen 0,5 nm und 5 nm, vorzugsweise zwischen 0,5 nm und 3 nm beträgt. Der Abstand B wird erfindungsgemäß durch das Dünnen beeinflusst beziehungsweise hergestellt.

Eine Vorrichtung zur Ausführung des Verfahrens ist erfindungsgemäß mit einer Kammer zur Ausbildung des Reservoirs und einer, insbesondere separat dazu vorgesehenen Kammer zur Füllung des Reservoirs und einer, insbesondere separat vorgesehenen Kammer zur Ausbildung des Pre-Bonds ausgebildet, die direkt über ein Vakuumsystem miteinander verbunden sind.

In einer weiteren Ausführungsform kann das Auffüllen des Reservoirs auch direkt über die Atmosphäre erfolgen, also entweder in einer Kammer, die zur Atmosphäre hin geöffnet werden kann oder einfach auf einem Aufbau, welcher keine Ummantelung besitzt aber den Wafer semi- und/oder vollautomatisch handhaben kann.

Die Erfindung wird insbesondere wie nachfolgend in Ihrer allgemeinsten Form offenbart:
1. Verfahren zum Bonden einer ersten Kontaktfläche (3) eines ersten Substrats (1) mit einer zweiten Kontaktfläche (4) eines zweiten Substrats (2), wobei das zweite Substrat (2) zumindest eine Reaktionsschicht (7) aufweist, mit folgenden Schritten, insbesondere folgendem Ablauf:
   - Aufnahme der Substrate (1, 2) in eine Plasmakammer (20, 20') oder in eine an eine Plasmakammer (20") angeschlossene Substratkammer (27), wobei die Plasmakammer (20, 20', 20") mindestens zwei mit unterschiedlichen Frequenzen (f₂₁, f₂₂) betreibbare, insbesondere mit unterschiedlichen Frequenzen (f₂₁, f₂₂) betriebene, Generatoren (23, 24) zur Erzeugung des Plasmas aufweist,
   - Ausbildung eines Reservoirs (5) in einer Reservoirbildungsschicht (6) an der ersten Kontaktfläche (3) durch Beaufschlagung der ersten Kontaktfläche (3) mit einem in der Plasmakammer (20, 20', 20") erzeugten Plasma,
   - zumindest teilweises Auffüllen des Reservoirs (5) mit einem ersten Edukt oder einer ersten Gruppe von Edukten,
   - Kontaktieren der ersten Kontaktfläche (3) mit der zweiten Kontaktfläche (4) zur Ausbildung einer Pre-Bond-Verbindung,
   - Ausbildung eines permanenten Bonds zwischen der ersten und zweiten Kontaktfläche (3, 4), zumindest teilweise verstärkt durch Reaktion des ersten Edukts mit einem in der Reaktionsschicht (7) des zweiten Substrats (2) enthaltenen zweiten Edukt.
2. Verfahren nach 1, bei dem die erste Frequenz (f₂₁) zwischen 1Hz und 20MHz, insbesondere zwischen 1kHz und 1MHz, bevorzugt zwischen 10kHz und 800kHz, noch bevorzugter zwischen 300kHz und 500kHz, liegt und/oder die erste Elektrode (21) in einem ersten Frequenzbereich 1Hz und 20MHz, insbesondere zwischen 1kHz und 1kHz, bevorzugt zwischen 10kHz und 800kHz, noch bevorzugter zwischen 300kHz und 500kHz einstellbar ist.
3. Verfahren nach 1 oder 2, bei dem die zweite Frequenz (f₂₂) zwischen 1Hz und 20MHz, insbesondere zwischen 1kHz und 1MHz, bevorzugt zwischen 10kHz und 800kHz, noch bevorzugter zwischen 30kHz und 50kHz, liegt und/oder die zweite Elektrode (21) in einem zweiten Frequenzbereich 1Hz und 20MHz, insbesondere zwischen 1kHz und 1MHz, bevorzugt zwischen 1kHz und 800kHz, noch bevorzugter zwischen 30kHz und 50kHz einstellbar ist.
4. Verfahren nach 1, 2 oder 3, bei dem eine Spannungsamplitude der ersten und/oder zweiten Elektrode (21, 22) zwischen 1V und 1000V, insbesondere zwischen 100V und 800V, vorzugsweise zwischen 200V und 600V, noch bevorzugter zwischen 300V und 500V, liegt.
5. Verfahren zum Bonden einer ersten Kontaktfläche (3) eines ersten Substrats (1) mit einer zweiten Kontaktfläche (4) eines zweiten Substrats (2), wobei das zweite Substrat (2) zumindest eine Reaktionsschicht (7) aufweist, mit folgenden Schritten, insbesondere folgendem Ablauf:
   - Aufnahme der Substrate in eine induktiv gekoppelte Plasmakammer
   - Ausbildung eines Reservoirs (5) in einer Reservoirbildungsschicht (6) an der ersten Kontaktfläche (3) durch Beaufschlagung der ersten Kontaktfläche (3) mit einem mittels induktiven Kopplung der Spule (26) erzeugten Plasma, wobei an einem ersten Generator (23) während der Plasmaerzeugung eine von einer zweiten Frequenz (f₂₂) eines zweiten Generators (24) unterschiedliche erste Frequenz (f₂₁) angelegt wird,
   - zumindest teilweises Auffüllen des Reservoirs (5) mit einem ersten Edukt oder einer ersten Gruppe von Edukten,
   - Kontaktieren der ersten Kontaktfläche (3) mit der zweiten Kontaktfläche (4) zur Ausbildung einer Pre-Bond-Verbindung,
   - Ausbildung eines permanenten Bonds zwischen der ersten und zweiten Kontaktfläche (3, 4), zumindest teilweise verstärkt durch Reaktion des ersten Edukts mit einem in der Reaktionsschicht (7) des zweiten Substrats (2) enthaltenen zweiten Edukt.
6. Verfahren nach 1 oder 5, bei dem die Frequenz (f₂₁) des ersten Generators (23) zwischen 0.001 kHz und 100000 kHz, mit Vorzug zwischen 0.01 kHz und 10000 kHz, mit größerem Vorzug zwischen 0.1 kHz und 1000 kHz, mit allergrößtem Vorzug genau bei 400 kHz liegt und/oder der zweite Generator (24) in einem Frequenzbereich zwischen 0.001 kHz und 100000 kHz, mit Vorzug zwischen 0.01 kHz und 10000 kHz, mit größerem Vorzug zwischen 0.1 kHz und 1000 kHz einstellbar ist.
7. Vorrichtung zum Bonden einer ersten Kontaktfläche (3) eines ersten Substrats (1) mit einer zweiten Kontaktfläche (4) eines zweiten Substrats (2), wobei das zweite Substrat (2) zumindest eine Reaktionsschicht (7) aufweist, mit folgenden Merkmalen:
   - eine Bondkammer (20, 20', 27),
   - eine erste Elektrode (21) und eine gegenüberliegend angeordnete zweite Elektrode (22),
   - Aufnahmemitteln zur Aufnahme der Substrate (2, 3) zwischen die erste Elektrode (21) und die zweite Elektrode (22),
   - Reservoirbildungsmittel zur Ausbildung eines Reservoirs (5) in einer Reservoirbildungsschicht (6) an der ersten Kontaktfläche (3) durch Beaufschlagung der ersten Kontaktfläche (3) mit einem mittels kapazitiver Kopplung der Elektroden (21, 22) erzeugten Plasma, wobei an der ersten Elektrode (21) während der Plasmaerzeugung eine von einer zweiten Frequenz (f₂₂) der zweiten Elektrode (22) unterschiedliche erste Frequenz (f₂₁) anlegbar ist,
   - Mittel zum Kontaktieren der ersten Kontaktfläche (3) mit der zweiten Kontaktfläche (4) zur Ausbildung einer Pre-Bond-Verbindung.
8. Vorrichtung nach 7, bei dem die erste und/oder die zweite Frequenz (f₂₁, f₂₂) einstellbar sind.
9. Vorrichtung zum Bonden einer ersten Kontaktfläche (3) eines ersten Substrats (1) mit einer zweiten Kontaktfläche (4) eines zweiten Substrats (2), wobei das zweite Substrat (2) zumindest eine Reaktionsschicht (7) aufweist, mit folgenden Merkmalen:
   - eine Bondkammer (20, 20', 27),
   - eine Spule (26),
   - Aufnahmemitteln zur Aufnahme der Substrate (2, 3) innerhalb der Spule (26),
   - Reservoirbildungsmittel zur Ausbildung eines Reservoirs (5) in einer Reservoirbildungsschicht (6) an der ersten Kontaktfläche (3) durch Beaufschlagung der ersten Kontaktfläche (3) mit einem mittels kapazitiver Kopplung der Elektroden (21, 22) erzeugten Plasma, wobei an der ersten Elektrode (21) während der Plasmaerzeugung eine von einer zweiten Frequenz (f₂₂) der zweiten Elektrode (22) unterschiedliche erste Frequenz (f₂₁) anlegbar ist,
   - Mittel zum Kontaktieren der ersten Kontaktfläche (3) mit der zweiten Kontaktfläche (4) zur Ausbildung einer Pre-Bond-Verbindung.
10. Vorrichtung nach 9, bei dem die erste und/oder die zweite Frequenz (f₂₁, f₂₂) einstellbar sind.
11. Verfahren nach mindestens einem der Nummern 1 bis 6, bei dem das Verfahren in einer Bondkammer durchgeführt wird und die Bondkammer zumindest bei der Ausbildung des Reservoirs (5) mit einem Kammerdruck zwischen 0,1 und 0,9 mbar, insbesondere kleiner 0,7 mbar, vorzugsweise kleiner 0,5 mbar, noch bevorzugter kleiner 0,3 mbar, beaufschlagt wird.
12. Verfahren nach mindestens einer der Nummern 1 bis 6 oder 11, bei dem in der Bondkammer zumindest bei der Ausbildung des Reservoirs (5) O₂- und/oder N₂- und/oder Ar-Gas vorherrscht.
13. Vorrichtung zum Bonden einer ersten Kontaktfläche (3) eines ersten Substrats (1) mit einer zweiten Kontaktfläche (4) eines zweiten Substrats (2), wobei das zweite Substrat (2) zumindest eine Reaktionsschicht (7) aufweist, mit folgenden Merkmalen:
   - eine Plasmakammer (20") zur Erzeugung eines Plasmas, wobei die Plasmakammer (20") mindestens zwei mit unterschiedlichen Frequenzen (f₂₁, f₂₂) betreibbare, insbesondere mit unterschiedlichen Frequenzen (f₂₁, f₂₂) betriebene, Generatoren (23, 24) zur Erzeugung des Plasmas aufweist,
   - eine an die Plasmakammer angeschlossene Bondkammer (27),
   - Reservoirbildungsmittel zur Ausbildung eines Reservoirs (5) in einer Reservoirbildungsschicht (6) an der ersten Kontaktfläche (3) durch Beaufschlagung der ersten Kontaktfläche (3) mit dem in der Plasmakammer (20") erzeugten Plasma,
   - Mittel zum Kontaktieren der ersten Kontaktfläche (3) mit der zweiten Kontaktfläche (4) zur Ausbildung einer Pre-Bond-Verbindung.
14. Vorrichtung nach 1 oder 13, wobei zwischen der Plasmakammer (20") und der Bondkammer (27) eine schließbare Öffnung angeordnet ist.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Figur 1a: einen ersten Schritt des erfindungsgemäßen Verfahrens unmittelbar nach der Kontaktierung des ersten Substrats mit dem zweiten Substrat,
- Figur 1b: einen alternativen ersten Schritt des erfindungsgemäßen Verfahrens unmittelbar nach der Kontaktierung des ersten Substrats mit dem zweiten Substrat,
- Figur 2: einen vor der Kontaktierung erfolgenden Schritt des erfindungsgemäßen Verfahrens, nämlich das Dünnen des zweiten Substrats,
- Figur 3a und 3b: weitere Schritte des erfindungsgemäßen Verfahrens zur Ausbildung einer höheren Bondstärke,
- Figur 4: einen sich an die Schritte gemäß Figur 1a oder 1b, Figur 2 sowie Figuren 3a und 3b anschließender weiterer Schritt des erfindungsgemäßen Verfahrens mit in Kontakt stehenden Kontaktflächen der Substrate,
- Figur 5: einen erfindungsgemäßen Schritt zur Ausbildung eines irreversiblen/permanenten Bonds zwischen den Substraten,
- Figur 6: eine vergrößerte Darstellung der an den beiden Kontaktflächen während der Schritte gemäß Figur 4 und Figur 5 ablaufenden chemischen/physikalischen Vorgängen,
- Figur 7: eine weiter vergrößerte Darstellung der an der Grenzfläche zwischen den beiden Kontaktflächen ablaufenden chemischen/physikalischen Vorgänge während der Schritte gemäß Figur 4 und Figur 5,
- Figur 8: ein Diagramm zur erfindungsgemäßen Erzeugung des Reservoirs,
- Figur 9: eine schematische Darstellung einer mit Vakuum beaufschlagbaren kapazitiven Plasmakammer,
- Figur 10: eine schematische Darstellung einer mit Vakuum beaufschlagbaren induktiven Plasmakammer,
- Figur 11: eine schematische Darstellung einer mit Vakuum beaufschlagbaren Remoteplasmakammer und
- Figur 12: ein Diagramm zu Frequenzverläufen der Frequenzen der beiden Elektroden.

In den Figuren sind gleiche oder gleichwirkende Merkmale mit den gleichen Bezugszeichen gekennzeichnet.

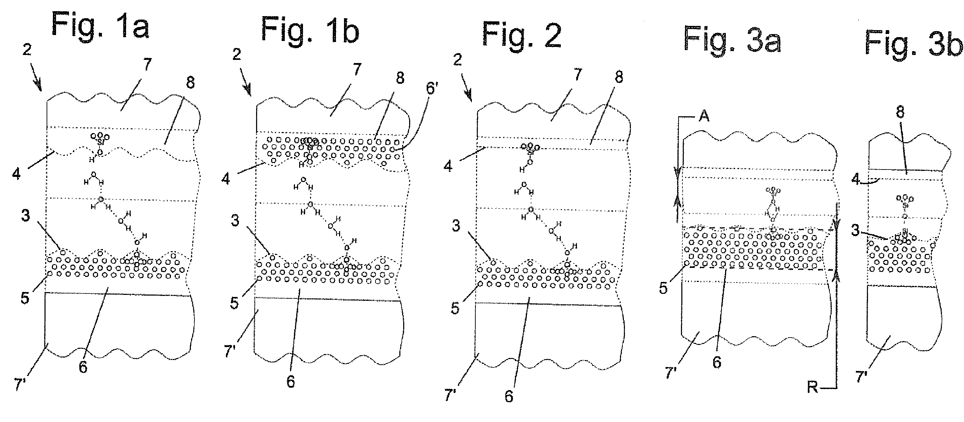

In der in Figur 1 dargestellten Situation, die nur einen Ausschnitt der beim oder unmittelbar nach dem Pre-Bond-Schritt zwischen einer ersten Kontaktfläche 3 eines ersten Substrats 1 und einer zweiten Kontaktfläche 4 eines zweiten Substrats 2 ablaufenden chemischen Reaktionen dargestellt. Die Oberflächen sind mit polaren OH-Gruppen terminiert und entsprechend hydrophil. Das erste Substrat 1 und das zweite Substrat 2 werden durch die Anziehungskraft der Wasserstoffbrücken zwischen den an der Oberfläche vorhandenen OH-Gruppen und den H₂O-Molekülen sowie zwischen den H₂O-Molekülen allein gehalten. Die Hydrophilizität zumindest des ersten Substrats 1 ist in einem vorangegangenen Schritt durch eine Plasmabehandlung erhöht worden.

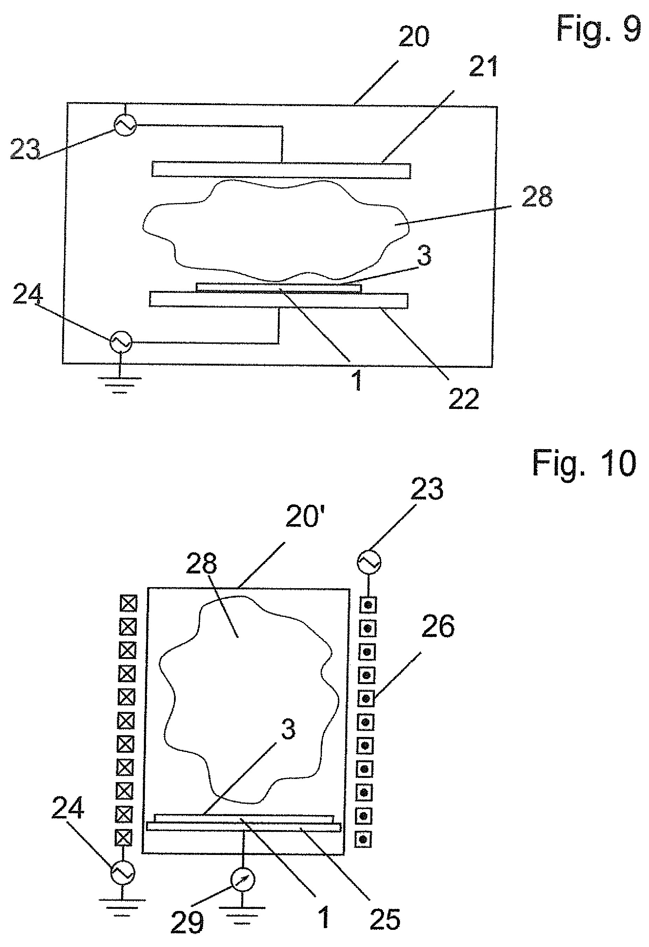

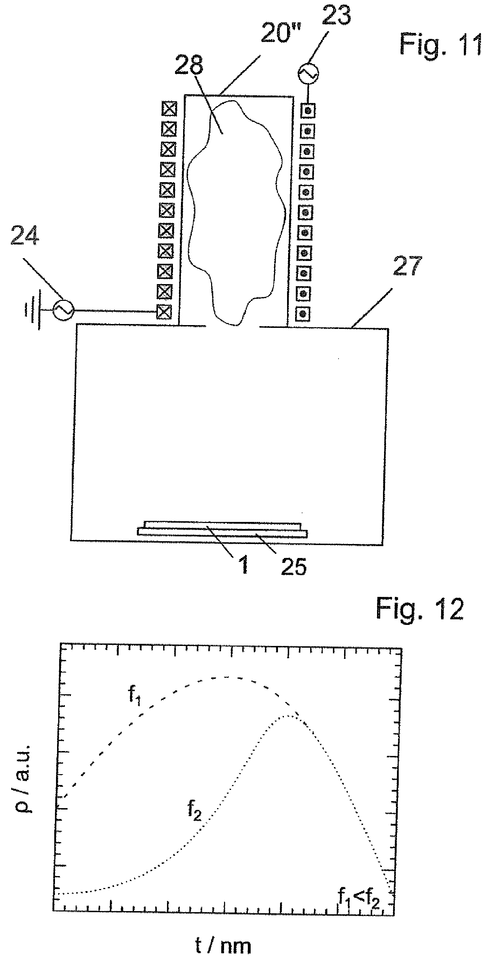

Die Plasmabehandlung erfolgt in einer mit Plasma und Vakuum und/oder einer definierten Gasatmosphäre beaufschlagbaren Plasmakammer 20 gemäß Figur 9. Mit Vakuum und/oder einer definierten Gasatmosphäre beaufschlagbar heißt, dass Drücke unter 1 mbar einstellbar und steuerbar sind. Als Gas wird beim hier beschriebenen Ausführungsbeispiel N₂ bei einem Druck von 0,3 mbar verwendet. Bei den erfindungsgemäßen Ausführungsformen der kapazitiven und induktiven Kopplung sind Plasmakammer 20 und Substratkammer identisch. Bei der erfindungsgemäßen Ausführungsform des Remoteplasmas gemäß Figur 11 ist die Plasmakammer 20" (besser: Plasmaerzeugungskammer) von einer das Substrat aufnehmenden Substratkammer 27 getrennt.

Die in Figur 9 gezeigte kapazitive Plasmakammer 20 weist eine (oben angeordnete oder obere) erste Elektrode 21 zur Ionisierung des Gasvolumens auf, die durch die an der ersten Elektrode 21 anliegende Wechselspannung mit einer Frequenz f₂₁ zwischen 0.001 kHz und 100000 kHz, mit Vorzug zwischen 0.01 kHz und 10000 kHz, mit größerem Vorzug zwischen 0.1 kHz und 1000 kHz, mit allergrößtem Vorzug zwischen 250 und 550 kHz und einer Amplitude zwischen 1V und 1000V, insbesondere zwischen 100V und 800V, vorzugsweise zwischen 200V und 600V, noch bevorzugter zwischen 300V und 500V hervorgerufen wird. Ein wichtiger Faktor ist dabei die mittlere freie Weglänge, die durch das oben beschriebene Vakuum definiert wird.

Eine weitere, der ersten Elektrode 21 gegenüberliegende (unten angeordnete oder untere) zweite Elektrode 22 ist nicht nur zur mit der Frequenz der ersten Elektrode 21 gekoppelten Beaufschlagung der ersten Kontaktfläche 3 vorgesehen, sondern weist zusätzlich eine den Aufprall der Plasmaionen dämpfende oder beschleunigende Biasspannung als Grundspannung auf. Bei der Biasspannung kann es sich im Allgemeinen um eine Wechselspannung oder eine Gleichspannung handeln. Mit Vorzug wird eine Gleichspannung verwendet, welche während dem Plasmaaktivierungsprozess dynamisch über eine, in einem gespeicherten/vorgegebenen Verlauf (Rezept) definierte Kurve verändert werden kann. Die zweite Elektrode 22 arbeitet in der hier gezeigten Ausführungsform mit einer Frequenz f₂₂ zwischen 0.001 kHz und 100000 kHz, mit Vorzug zwischen 0.01 kHz und 10000 kHz, mit größerem Vorzug zwischen 0.1 kHz und 1000 kHz, mit allergrößtem Vorzug von 15 kHz bis 55 kHz bei einer Amplitude zwischen 1V und 1000V, insbesondere zwischen 100V und 800V, vorzugsweise zwischen 200V und 600V, noch bevorzugter zwischen 300V und 500V. Diese zweite Wechselspannung führt auch zu einer Variation der Ionenenergie der Ionen, die auf die Oberfläche 3 auftreffen, womit eine gleichmäßige Tiefenverteilung der Ionen erreicht werden kann.

Die zweite Elektrode 21 dient zusätzlich als Aufnahme für das erste Substrat 1 mit dessen zur ersten Kontaktfläche 3 abgewandten Aufnahmeseite. Somit ist das erste Substrat 1 (ohne das zweite Substrat 2) zwischen der ersten Elektrode 21 und der zweiten Elektrode 22 angeordnet. Halterungen für die Elektroden 21, 22 sind nicht dargestellt.

Jede Elektrode 21, 22 ist vorzugsweise an eine eigene Stromversorgung in Form eines Generators 23 für die erste Elektrode 21 und eines separat hierzu steuerbaren zweiten Generators 24 für die zweite Elektrode 22 angeschlossen. Der erste Generator 23 arbeitet insbesondere zwischen 1 Watt und 100000 Watt, mit Vorzug zwischen 25 Watt und 10000 Watt, mit größerem Vorzug zwischen 30 Watt und 1000 Watt, mit größtem Vorzug zwischen 50 Watt und 200 Watt, mit allergrößtem Vorzug zwischen 70 Watt und 130 Watt. Der zweite Generator 24 erbringt ebenfalls eine Leistung zwischen 1 Watt und 100000 Watt, mit Vorzug zwischen 25 Watt und 10000 Watt, mit größerem Vorzug zwischen 30 Watt und 1000 Watt, mit größtem Vorzug zwischen 50 Watt und 200 Watt, mit allergrößtem Vorzug zwischen 70 Watt und 130 Watt.

Eine induktive Plasmakammer 20' gemäß Figur 10 weist eine sie umgebende Spule 26 auf, welche von einem Strom mit der Amplitude durchflossen wird. Das Substrat 1 liegt auf einem Probenhalter 25. In einer bevorzugten Ausführungsform weist die Plasmakammer 20' genau zwei Generatoren 23 und 24 auf.

Die induktive Plasmakammer 20' weist einen ersten Stromgenerator 23 an einer Seite der Spule 26 auf. Der die Spule 26 durchfließende Strom, erzeugt durch den ersten Generator 23, besitzt eine Frequenz f₂₁ zwischen 0.001 kHz und 100000 kHz, mit Vorzug zwischen 0.01 kHz und 10000 kHz, mit größerem Vorzug zwischen 0.1 kHz und 1000 kHz, mit allergrößtem Vorzug von genau 400 kHz und eine Amplitude zwischen 0.001 A und 10.000 A, mit Vorzug zwischen 0.41 A und 1000 A, mit größerem Vorzug zwischen 0.1 A und 100 A, mit größtem Vorzug zwischen 1 A und 10 A.

Bevorzugt besitzt die Spule 26 beziehungsweise die Plasmakammer 20' einen zweiten Stromgenerator 24. Der zweite Stromgenerator 24 besitzt eine Frequenz f₂₂ zwischen 0.001 kHz und 100000 kHz, mit Vorzug zwischen 0.01 kHz und 10000 kHz, mit größerem Vorzug zwischen 0.1 kHz und 1000 kHz, mit allergrößtem Vorzug von genau 400 kHz und eine Amplitude zwischen 0.001 A und 10.000 A, mit Vorzug zwischen 0.01 A und 1000 A, mit größerem Vorzug zwischen 0.1 A und 100 A, mit größtem Vorzug zwischen 1 A und 10 A.

In einer weiteren Ausführungsform gemäß Figur 11 wird das zu erzeugende Plasma in einer (Remote-)Plasmakammer 20" erzeugt. Alle offenbarten Parameter für das kapazitiv und/oder induktiv gekoppelte Plasma gelten analog.

Fig. 12 zeigt schematisch die Porendichte des erfindungsgemäß erzeugten Plasmas als Funktion der Tiefe für zwei unterschiedliche Frequenzen. Es ist evident, dass durch eine Frequenzänderung das Dichteprofil gezielt einstellbar ist.

Besonders vorteilhaft ist es, gemäß der alternativen Ausführungsform zusätzlich das zweite Substrat 2 beziehungsweise die zweite Kontaktfläche 4 einer Plasmabehandlung zu unterziehen, insbesondere gleichzeitig mit der Plasmabehandlung des ersten Substrats 1.

Durch die Plasmabehandlung ist erfindungsgemäß ein Reservoir 5 in einer aus thermischem Siliziumdioxid bestehenden Reservoirbildungsschicht 6 sowie bei der alternativen Ausführungsform gemäß Figur 1b ein zweites, gegenüberliegendes Reservoir 5' in der Reservoirbildungsschicht 6' ausgebildet worden. Unter den Reservoirbildungsschichten 6, 6'schließen sich jeweils unmittelbar Reaktionsschichten 7, 7' an, die ein zweites Edukt oder eine zweite Gruppe von Edukten enthalten. Durch die Plasmabehandlung mit N₂-Ionen mit der oben genannten Ionenenergie wird eine mittlere Dicke R des Reservoirs 5 von etwa 15 nm erreicht, wobei die Ionen Kanäle beziehungsweise Poren in der Reservoirbildungsschicht 6 ausbilden.

Zwischen der Reservoirbildungsschicht 6 und der Reaktionsschicht 7 ist eine Aufwuchsschicht 8 an dem zweiten Substrat 2 vorgesehen, die gleichzeitig zumindest teilweise die Reservoirbildungsschicht 6' sein kann. Entsprechend kann zusätzlich eine weitere Aufwuchsschicht zwischen der Reservoirbildungsschicht 6' und der Reaktionsschicht 7' vorgesehen sein.

Ebenfalls vor dem in Figur 1 gezeigten Schritt und nach der Plasmabehandlung wird das Reservoir 5 (und ggf. das Reservoir 5') zumindest überwiegend mit H₂O als erstes Edukt aufgefüllt. Im Reservoir 5 können sich auch reduzierte Spezies der im Plasmaprozess vorhandenen Ionen befinden, insbesondere O₂, N₂, H₂, Ar.

Vor oder nach der Ausbildung des/der Reservoirs 5, 5', jedenfalls vor dem Kontaktieren der Substrate 1, 2, wird die Aufwuchsschicht 8 (und ggf. die weitere Aufwuchsschicht) durch Ätzen gedünnt (hier nach der Ausbildung des Reservoirs 5, siehe Figur 2). Hierdurch wird der mittlere Abstand B zwischen der zweiten Kontaktfläche 4 und der Reaktionsschicht 7 reduziert. Gleichzeitig wird die zweite Kontaktfläche 4 mit Vorteil ebener.

Die Kontaktflächen 3, 4 weisen nach Kontaktierung in dem in den Figuren 1a oder 1b gezeigten Stadium noch einen relativ weiten Abstand auf, insbesondere bedingt durch das zwischen den Kontaktflächen 3, 4 vorhandene Wasser. Entsprechend ist die vorhandene Bondstärke relativ gering und liegt etwa zwischen 100 mJ/cm² und 300 mJ/cm², insbesondere über 200 mJ/cm². Hierbei spielt die vorherige Plasmaaktivierung, insbesondere wegen der erhöhten Hydrophilizität der plasmaaktivierten ersten Kontaktfläche 3 sowie einem durch die Plasmaaktivierung verursachten Glättungseffekt, eine entscheidende Rolle.

Der in Fig. 1 dargestellte, als Prebond bezeichnete, Vorgang kann vorzugsweise bei Umgebungstemperatur oder maximal 50° Celsius ablaufen. Die Fig. 3a und 3b zeigen einen hydrophilen Bond, wobei die Si-O-Si Brücke unter Abspaltung von Wasser durch -OH terminierte Oberflächen zustande kommt. Die Vorgänge in Fig. 3a und 3b dauern bei Raumtemperatur ca. 300h. Bei 50°C ca. 60h. Der Zustand in Fig. 3b tritt ohne Herstellung des Reservoirs 5 (bzw. der Reservoirs 5, 5') bei den genannten Temperaturen nicht auf.

Zwischen den Kontaktflächen 3, 4 werden H₂O-Moleküle gebildet, die zumindest teilweise für eine weitere Auffüllung im Reservoir 5 sorgen, soweit noch Freiraum vorhanden ist. Die übrigen H₂O-Moleküle werden entfernt. In der Stufe gemäß Figur 1 sind etwa 3 bis 5 Einzelschichten von OH-Gruppen beziehungsweise H₂O vorhanden und vom Schritt gemäß Figur 1 zum Schritt gemäß Figur 3a werden 1 bis 3 Monolagen von H₂O entfernt beziehungsweise im Reservoir 5 aufgenommen.

In dem in Figur 3a gezeigten Schritt sind die Wasserstoffbrückenbindungen nunmehr unmittelbar zwischen Siloxan-Gruppen gebildet, wodurch eine stärkere Bondkraft entsteht. Hierdurch werden die Kontaktflächen 3, 4 stärker aneinander gezogen und der Abstand zwischen den Kontaktflächen 3, 4 wird reduziert. Es liegen dementsprechend nur noch 1 bis 2 Einzelschichten von OH-Gruppen zwischen den Kontaktflächen 1, 2 vor.

In dem in Figur 3b gezeigten Schritt werden nunmehr wiederum unter Abscheidung von H₂O-Molekülen gemäß nachfolgend eingeblendeter Reaktion kovalente Verbindungen in Form von Silanol-Gruppen zwischen den Kontaktflächen 3, 4 gebildet, die zu einer deutlich stärkeren Bondkraft führen und weniger Platz benötigen, so dass der Abstand zwischen den Kontaktflächen 3, 4 weiter verringert wird, bis schließlich der in Figur 3 gezeigte minimale Abstand auf Grund des direkten Aufeinandertreffens der Kontaktflächen 3, 4 erreicht wird:

Si-OH + HO-Si ←→ Si-O-Si+H₂O

Bis zur Stufe 3 ist es, insbesondere wegen der Schaffung des Reservoirs 5 (und ggf. des zusätzlichen Reservoirs 5'), nicht notwendig, die Temperatur übermäßig zu erhöhen, eher sogar bei Raumtemperatur ablaufen zu lassen. Auf diese Weise ist ein besonders schonender Ablauf der Verfahrensschritte gemäß Figur 1a oder 1b bis Figur 4 möglich.

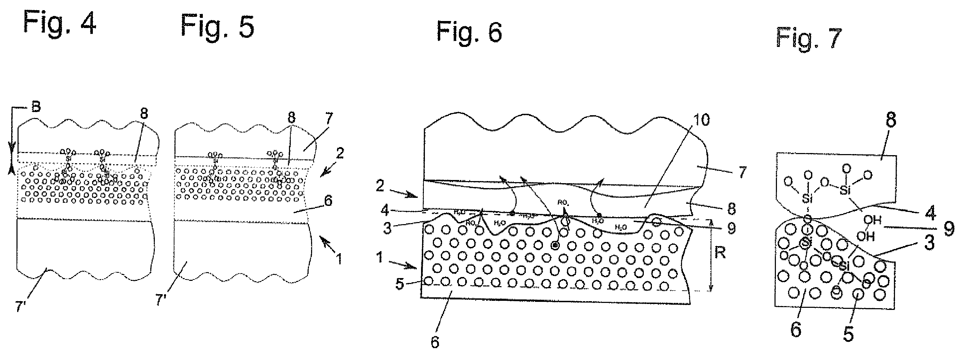

In dem in Figur 5 gezeigten Verfahrensschritt wird die Temperatur mit Vorzug auf maximal 500° Celsius, mit größerem Vorzug auf maximal 300°C mit noch größerem Vorzug auf maximal 200°C, mit größtem Vorzug auf maximal 100°C, mit allergrößtem Vorzug nicht über Raumtemperatur erhöht, um einen irreversiblen beziehungsweise permanenten Bond zwischen der ersten und der zweiten Kontaktfläche zu schaffen. Diese, im Gegensatz zum Stand der Technik, relativ niedrigen Temperaturen sind nur möglich, weil das Reservoir 5 (und ggf. zusätzlich das Reservoir 5') das erste Edukt für die in Figur 6 und 7 gezeigte Reaktion umfasst:

Si + 2H₂O → SiO₂ + 2H₂

Durch Vergrößerung des molaren Volumens und Diffusion der H₂O-Moleküle wächst insbesondere an der Grenzfläche zwischen der Reservoirbildungsschicht 6' und der Reaktionsschicht 7 (und ggf. zusätzlich an der Grenzfläche zwischen der Reservoirbildungsschicht 6 und der Reaktionsschicht 7') Volumen in Form einer Aufwuchsschicht 8 an, wobei wegen des Ziels einer Minimierung der freien Gibb'schen Enthalpie ein verstärktes Anwachsen in Bereichen erfolgt, wo Lücken 9 zwischen den Kontaktflächen 3, 4 vorhanden sind. Durch die Volumenerhöhung der Aufwuchsschicht 8 werden die Lücken 9 geschlossen. Hierzu genauer:

Bei den obengenanten, leicht erhöhten Temperaturen diffundieren H₂O-Moleküle als erstes Edukt von dem Reservoir 5 (beziehungsweise den Reservoirs 5, 5') zur Reaktionsschicht 7 (und gegebenenfalls 7'). Diese Diffusion kann entweder über einen Direktkontakt der als Oxidschichten ausgebildeten Reservoirbildungsschicht 6, 6' mit der jeweiligen Reaktionsschicht 7, 7' (oder Aufwuchsschicht 8), oder über eine/aus einer zwischen den Oxidschichten vorliegende Lücke 9, erfolgen. Dort wird Siliziumdioxid, also eine chemische Verbindung mit einem größeren molaren Volumen als reines Silizium, als Reaktionsprodukt 10 der obigen Reaktion aus der Reaktionsschicht 7 gebildet. Das Siliziumdioxid wächst an der Grenzfläche der Reaktionsschicht 7 mit der Aufwuchsschicht 8 und/oder der Reservoirbildungsschicht 6, 6' an und formt dadurch die, insbesondere als natives Oxid ausgebildete, Aufwuchsschicht 8 in Richtung der Lücken 9 aus. Auch hierbei werden H₂O-Moleküle aus dem Reservoir benötigt.

Durch die Existenz der Lücken, die im Nanometerbereich liegen, besteht die Möglichkeit des Ausbeulens der Aufwuchsschicht 8, wodurch Spannungen an den Kontaktflächen 3, 4 reduziert werden können. Hierdurch wird der Abstand zwischen den Kontaktflächen 3, 4 reduziert, wodurch sich die wirksame Kontaktfläche und damit die Bondstärke weiter erhöhen. Die so zustande gekommene, sich über den gesamten Wafer ausbildende, alle Poren verschließende, Schweißverbindung trägt, im Gegensatz zu den partiell nicht verschweißten Produkten im Stand der Technik, fundamental zur Erhöhung der Bondkraft bei. Der Bindungstyp zwischen beiden miteinander verschweißten amorphen Siliziumoxidoberflächen ist eine Mischform aus kovalentem und ionischem Anteil sein.

Besonders schnell beziehungsweise bei möglichst niedrigen Temperaturen erfolgt die oben genannte Reaktion des ersten Edukts (H₂O) mit dem zweiten Edukt (Si) in der Reaktionsschicht 7, soweit ein mittlerer Abstand B zwischen der ersten Kontaktfläche 3 und der Reaktionsschicht 7 möglichst gering ist.

Entscheidend ist daher die Vorbehandlung des ersten Substrats 1 sowie die Auswahl/Vorbehandlung des zweiten Substrats 2, das aus einer Reaktionsschicht 7 aus Silizium und einer möglichst dünnen nativen Oxidschicht als Aufwuchsschicht 8 besteht. Eine möglichst dünne native Oxidschicht ist aus zwei Gründen erfindungsgemäß vorgesehen. Die Aufwuchsschicht 8 ist sehr dünn, insbesondere durch das erfindungsgemäß vorgesehene Dünnen, damit sie sich durch das neu gebildete Reaktionsprodukt 10 an der Reaktionsschicht 7 zur als Oxidschicht ausgebildeten Reservoirbildungsschicht 6 des gegenüberliegenden Substrats 1 hin ausbeulen kann, und zwar vorwiegend in Bereichen der Nano-Lücken 9. Des Weiteren sind möglichst kurze Diffusionswege erwünscht, um den erwünschten Effekt möglichst rasch und bei möglichst niedriger Temperatur zu erzielen. Das erste Substrat 1 besteht ebenfalls aus einer Siliziumschicht und einer darauf erzeugten Oxidschicht als Reservoirbildungsschicht 6, in der zumindest teilweise oder vollständig ein Reservoir 5 ausgebildet wird.

In dem Reservoir 5 (beziehungsweise den Reservoirs 5, 5') wird erfindungsgemäß mindestens die zum Schließen der Nano-Lücken 9 erforderliche Menge an erstem Edukt aufgefüllt, damit ein optimales Aufwachsen der Aufwuchsschicht 8 zum Schließen der Nano-Lücken 9 in möglichst kurzer Zeit und/oder bei möglichst geringer Temperatur erfolgen kann.

### Vorrichtung zum permanenten Bonden von Wafern

### Bezugszeichenliste

- 1: erstes Substrat
- 2: zweites Substrat
- 3: erste Kontaktfläche
- 4: zweite Kontaktfläche
- 5, 5': Reservoir
- 6, 6': Reservoirbildungsschicht
- 7, 7': Reaktionsschicht
- 8: Aufwuchsschicht
- 9: Nano-Lücken 10 Reaktionsprodukt
- 11: Erstes Profil
- 12: Zweites Profil
- 13: Summenkurve
- 20, 20', 20": Plasmakammer
- 21: Erste Elektrode
- 22: Zweite Elektrode
- 23: Erster Generator
- 24: Zweiter Generator
- 25: Substrathalter
- 26: Spule
- 27: Substratkammer bei Remoteplasma
- 28: Induziertes Plasma
- 29: Gleichspannungsquelle
- A: mittlere Dicke
- B: mittlerer Abstand
- R: mittlere Dicke
- f₂₁: Erste Frequenz
- f₂₂: Zweite Frequenz

## Patentansprüche

1. Vorrichtung zum Bonden einer ersten Kontaktfläche (3) eines ersten Substrats (1) mit einer zweiten Kontaktfläche (4) eines zweiten Substrats (2), wobei das zweite Substrat (2) zumindest eine Reaktionsschicht (7) aufweist, mit folgenden Merkmalen:
- eine Bondkammer (20, 20', 27),
- eine erste Elektrode (21) und eine gegenüberliegend angeordnete zweite Elektrode (22),
- Aufnahmemitteln zur Aufnahme der Substrate (2, 3) zwischen die erste Elektrode (21) und die zweite Elektrode (22),
- Reservoirbildungsmittel zur Ausbildung eines Reservoirs (5) in einer Reservoirbildungsschicht (6) an der ersten Kontaktfläche (3) durch Beaufschlagung der ersten Kontaktfläche (3) mit einem mittels kapazitiver Kopplung der Elektroden (21, 22) erzeugten Plasma, wobei an der ersten Elektrode (21) während der Plasmaerzeugung eine von einer zweiten Frequenz (f₂₂) der zweiten Elektrode (22) unterschiedliche erste Frequenz (f₂₁) anlegbar ist,
- Mittel zum Kontaktieren der ersten Kontaktfläche (3) mit der zweiten Kontaktfläche (4) zur Ausbildung einer Pre-Bond-Verbindung,
wobei die Vorrichtung eine Kammer zur Ausbildung des Reservoirs und eine separat dazu vorgesehene Kammer zur Füllung des Reservoirs und einer, insbesondere separat vorgesehenen Kammer zur Ausbildung der Pre-Bond-Verbindung aufweist, die direkt über ein Vakuumsystem miteinander verbunden sind.

2. Vorrichtung nach Anspruch 1, bei dem die erste und/oder die zweite Frequenz (f₂₁, f₂₂) einstellbar sind.

3. Vorrichtung zum Bonden einer ersten Kontaktfläche (3) eines ersten Substrats (1) mit einer zweiten Kontaktfläche (4) eines zweiten Substrats (2), wobei das zweite Substrat (2) zumindest eine Reaktionsschicht (7) aufweist, mit folgenden Merkmalen:
- eine Bondkammer (20, 20', 27),
- eine Spule (26),
- Aufnahmemitteln zur Aufnahme der Substrate (2, 3) innerhalb der Spule (26),
- Reservoirbildungsmittel zur Ausbildung eines Reservoirs (5) in einer Reservoirbildungsschicht (6) an der ersten Kontaktfläche (3) durch Beaufschlagung der ersten Kontaktfläche (3) mit einem mittels kapazitiver Kopplung der Elektroden (21, 22) erzeugten Plasma, wobei an der ersten Elektrode (21) während der Plasmaerzeugung eine von einer zweiten Frequenz (f₂₂) der zweiten Elektrode (22) unterschiedliche erste Frequenz (f₂₁) anlegbar ist,
- Mittel zum Kontaktieren der ersten Kontaktfläche (3) mit der zweiten Kontaktfläche (4) zur Ausbildung einer Pre-Bond-Verbindung.
wobei die Vorrichtung eine Kammer zur Ausbildung des Reservoirs und eine separat dazu vorgesehene Kammer zur Füllung des Reservoirs und einer, insbesondere separat vorgesehenen Kammer zur Ausbildung der Pre-Bond-Verbindung aufweist, die direkt über ein Vakuumsystem miteinander verbunden sind.

4. Vorrichtung nach Anspruch 3, bei dem die erste und/oder die zweite Frequenz (f₂₁, f₂₂) einstellbar sind.

5. Vorrichtung zum Bonden einer ersten Kontaktfläche (3) eines ersten Substrats (1) mit einer zweiten Kontaktfläche (4) eines zweiten Substrats (2), wobei das zweite Substrat (2) zumindest eine Reaktionsschicht (7) aufweist, mit folgenden Merkmalen:
- eine Plasmakammer (20") zur Erzeugung eines Plasmas, wobei die Plasmakammer (20'') mindestens zwei mit unterschiedlichen Frequenzen (f₂₁, f₂₂) betreibbare, insbesondere mit unterschiedlichen Frequenzen (f₂₁, f₂₂) betriebene, Generatoren (23, 24) zur Erzeugung des Plasmas aufweist,
- eine an die Plasmakammer angeschlossene Bondkammer (27),
- Reservoirbildungsmittel zur Ausbildung eines Reservoirs (5) in einer Reservoirbildungsschicht (6) an der ersten Kontaktfläche (3) durch Beaufschlagung der ersten Kontaktfläche (3) mit dem in der Plasmakammer (20") erzeugten Plasma,
- Mittel zum Kontaktieren der ersten Kontaktfläche (3) mit der zweiten Kontaktfläche (4) zur Ausbildung einer Pre-Bond-Verbindung.
wobei die Vorrichtung eine Kammer zur Ausbildung des Reservoirs und eine separat dazu vorgesehene Kammer zur Füllung des Reservoirs und einer, insbesondere separat vorgesehenen Kammer zur Ausbildung der Pre-Bond-Verbindung aufweist, die direkt über ein Vakuumsystem miteinander verbunden sind.

6. Vorrichtung nach Anspruch 1 oder 5, wobei zwischen der Plasmakammer (20") und der Bondkammer (27) eine schließbare Öffnung angeordnet ist.
